(19) Europäisches Patentamt / European Patent Office / Office européen des brevets

(11) **EP 3 164 939 B1**

(12) **EUROPÄISCHE PATENTSCHRIFT**

(45) Veröffentlichungstag und Bekanntmachung des Hinweises auf die Patenterteilung:
**20.06.2018 Patentblatt 2018/25**

(21) Anmeldenummer: **15722353.8**

(22) Anmeldetag: **28.04.2015**

(51) Int Cl.:
*H03F 3/30* *(2006.01)*     *H03F 3/45* *(2006.01)*

(86) Internationale Anmeldenummer:
**PCT/EP2015/059157**

(87) Internationale Veröffentlichungsnummer:
**WO 2016/000844 (07.01.2016 Gazette 2016/01)**

(54) **REGELUNGSEINRICHTUNG FÜR EINEN TRANSKONDUKTANZVERSTÄRKER**

CONTROL DEVICE FOR A TRANSCONDUCTANCE AMPLIFIER

DISPOSITIF DE RÉGLAGE POUR UN AMPLIFICATEUR À TRANSCONDUCTANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.07.2014 DE 102014212775**

(43) Veröffentlichungstag der Anmeldung:
**10.05.2017 Patentblatt 2017/19**

(73) Patentinhaber: **Robert Bosch GmbH
70442 Stuttgart (DE)**

(72) Erfinder:
• **RITZMANN, Steffen
72770 Reutlingen (DE)**
• **ROSAHL, Thoralf
72800 Eningen (DE)**

(56) Entgegenhaltungen:
WO-A1-2012/120570     US-A1- 2006 044 056
US-A1- 2007 152 752     US-B1- 6 529 077
US-B1- 6 894 563

EP 3 164 939 B1

**Beschreibung**

Die Erfindung betrifft eine Regelungseinrichtung für einen Transkonduktanzverstärker. Die Erfindung betrifft ferner ein Verfahren zum Betreiben eines Transkonduktanzverstärkers.

Stand der Technik

In bekannten elektronischen Systembausteinen werden sowohl Linear- als auch Schaltregler verwendet, um die Systembausteine und deren Peripherien mit elektrischer Energie zu versorgen. Als Fehlerverstärker werden in Abhängigkeit vom Typ einer Kompensation auch Transkonduktanzverstärker (engl.

Operational Transconductance Amplifier OTA) verwendet, die eine Spannungsänderung am Eingang in eine Stromänderung am Ausgang umsetzen und bei denen durch technologische Toleranzen (z.B. Herstellungstoleranzen) sowie aufgrund von Temperaturschwankungen eine Steilheit variieren kann.

Da die Steilheit direkt in eine Verstärkung des Regelkreises eingeht, kann damit auch die Transitfrequenz des Reglers variieren und, damit verbunden, eine dynamische Lastausregelung bzw. Anforderungen an externe Komponenten.

Bekannt sind Referenzstromstufen, z.B. in Form von PTAT-Stufen (engl. Proportional-to-absolute-temperature), mit denen eine Temperaturabhängigkeit ausgeglichen werden kann. Beispiele für geregelte Referenzstromstufen sind in US2007/0152752 und WO2012/120570 offenbart.

Offenbarung der Erfindung

Eine Aufgabe der Erfindung ist es daher, eine verbesserte Betriebscharakteristik eines Transkonduktanzverstärkers bereitzustellen.

Die Aufgabe wird gemäß einem ersten Aspekt mit einer Regelungseinrichtung für einen Transkonduktanzverstärker wie in Anspruch 1 beansprucht, gelöst. Gemäß einem zweiten Aspekt wird die Erfindung mit einem Verfahren zum Betreiben eines Transkonduktanzverstärkers mittels einer Regelungseinrichtung wie in Anspruch 6 beansprucht, gelöst. Vorteilhafte Weiterbildungen der Regelungseinrichtung sind Gegenstand von Unteransprüchen.

Auf diese Weise wird eine schaltungstechnische Umsetzung einer Regelung der Steilheit des Differenzpaars des Transkonduktanzverstärkers durch eine elektrische Differenzspannung und einen elektrischen Referenzstrom der Regelungseinrichtung realisiert.

Eine vorteilhafte Weiterbildung der Regelungseinrichtung zeichnet sich dadurch aus, dass die Differenzspannung für das Differenzpaar der Regelungseinrichtung derart dimensioniert ist, dass der Transkonduktanzverstärker im linearen Bereich arbeitet. Unter der Voraussetzung, dass sich der Transkonduktanzverstärker im linearen Operationsbereich befindet, ist eine Symmetrie zwischen den Biasströmen der beiden Differenzpaare vorhanden, die schaltungstechnisch ausgenutzt wird.

Eine weitere vorteilhafte Weiterbildung der Regelungseinrichtung sieht vor, dass die Differenzspannung und/oder der Referenzstrom definiert einstellbar ist. Auf diese Weise kann beispielsweise mittels geeigneten Spannungsteilerabgriffen eine elektrische Spannung einer Spannungsreferenz geteilt werden. Somit kann je nach Anwendungsfall die Steilheit des Differenzpaars des Transkonduktanzverstärkers bis zu einem gewissen Grad variiert werden.

Eine weitere vorteilhafte Weiterbildung der Regelungseinrichtung ist dadurch gekennzeichnet, dass zwischen den Biasströmen ein Übersetzungsverhältnis vorsehbar ist. Mittels des Übersetzungsverhältnisses, das beispielsweise durch geometrische Ausgestaltungen von Transistoren realisierbar ist, kann eine Steilheit des Differenzpaars des Transkonduktanzverstärkers in eine Steilheit des Differenzpaars der Regelungseinrichtung umgerechnet werden.

Die Erfindung wird im Folgenden mit weiteren Vorteilen und Merkmalen anhand von zwei Figuren detailliert beschrieben. Dabei bilden alle Merkmale, unabhängig von ihrer Darstellung in der Beschreibung bzw. in den Figuren und unabhängig von ihrer Rückbeziehung in den Patentansprüchen den Gegenstand der Erfindung. Die Figuren sind insbesondere zur Verdeutlichung der erfindungsgemäßen Prinzipien gedacht und können nicht als Detailschaltbilder verstanden werden.

In den Figuren zeigt:

Fig. 1　eine prinzipielle Darstellung einer Ausführungsform der erfindungsgemäßen Regelungseinrichtung; und

Fig. 2　einen prinzipiellen Ablauf einer Ausführungsform des erfindungsgemäßen Verfahrens.

Beschreibung von Ausführungsformen

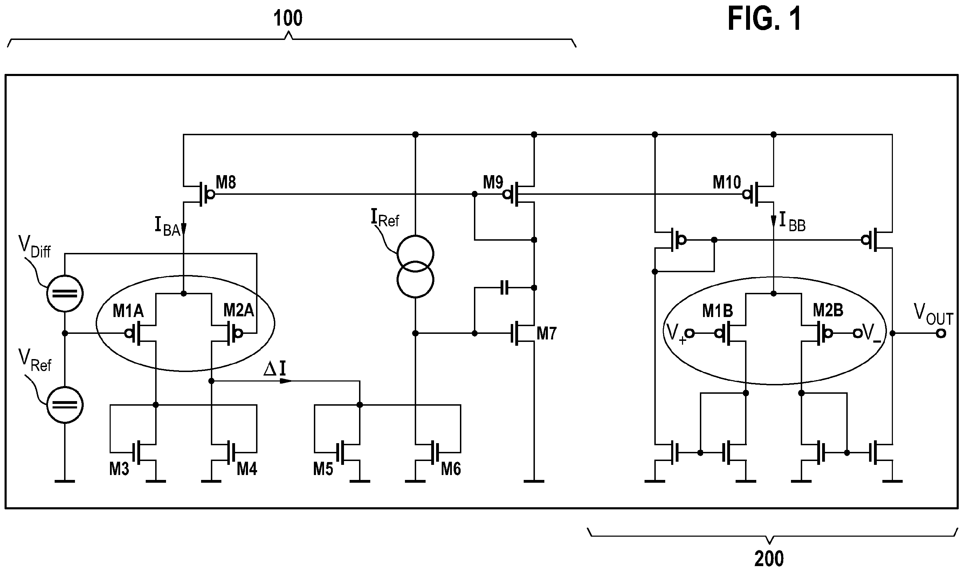

Fig. 1 zeigt ein prinzipielles Schaltbild einer Ausführungsform einer erfindungsgemäßen Regelungseinrichtung 100 für einen Transkonduktanzverstärker 200. Die Regelungseinrichtung 100 umfasst ein Differenzpaar M1A, M2A, das eine technologische Replika, bzw. ein technologisches Abbild bzw. eine technologische Nachbildung eines Differenzpaares M1B, M2B eines symmetrischen Transkonduktanzverstärker 200 ausgebildet ist. Das Differenzpaar M1A, M2A mit zwei MOS-FETs ist dabei auf dem gleichen anwendungsspezifischen IC (engl. ASIC) wie das Differenzpaar M1B, M2B angeordnet und damit in enger räumlicher Nähe zum Differenzpaar M1B, M2B des Transkonduktanzverstärkers 200 angeordnet. Auf diese Weise sind physikalische Eigenschaften der beiden Differenzpaare M1A, M2A und M1B, M2B, z.B. hinsichtlich Abgleichs verhalten (engl. Matching) sehr ähnlich ausgebildet.

Auf der Regelungseinrichtung 100 ist eine Referenzspannungsquelle $V_{Ref}$, vorzugsweise als eine Band Gap mit 1.25V angeordnet. Die Referenzspannungsquelle $V_{Ref}$ bildet eine genaue, temperaturunabhängige Spannungsreferenz, die zur Ausbildung einer elektrischen Differenzspannung $V_{diff}$ zum Ansteuern des Differenzpaars M1A, M2A dient. Ferner ist auf der Regelungseinrichtung 100 eine genaue, temperaturunabhängige Stromreferenzquelle angeordnet, die als Quelle für einen elektrischen Referenzstrom $I_{Ref}$ dient. Die Differenzspannung $V_{Ref}$, der Referenzstrom $I_{Ref}$ sowie die Abgleichs-Eigenschaften der beiden Differenzpaare M1A, M2A und M1B, M2B bestimmen eine Genauigkeit, mit der eine Steilheit $g_{mB}$ des Differenzpaars M1 B, M2B des Transkonduktanzverstärkers 200 eingestellt bzw. geregelt werden kann.

Ein erster Stromspiegel M3, M4 ist galvanisch mit dem Differenzpaar M1A, M2A verbunden. Ein Pfad der Verbindung zwischen dem Transistor M2A mit dem Transistor M4 des ersten Stromspiegels M3, M4 ist mit einem Transistor M5 galvanisch verbunden, der Teil eines zweiten Stromspiegels M5, M6 ist.

Mittels der Spannungsquelle $V_{diff}$ wird an die beiden Eingänge des Differenzpaares M1A, M2A eine elektrische Spannung, beispielsweise 100mV angelegt. Der Referenzstrom $I_{Ref}$ wird in einen zweiten Stromspiegel M5, M6 eingeprägt.

Im Falle eines ausgeregelten Zustands des Transkonduktanzverstärkers 200 bzw. der Regelungseinrichtung 100 fließt kein Differenzstrom ΔI im Verbindungspfad zwischen dem Transistor M4 und dem Transistor M5.

Für den Fall jedoch, dass ein ungeregelter Zustand des Transkonduktanzverstärkers 200 bzw. der Regelungseinrichtung 100 vorliegt, zum Beispiel aufgrund von erhöhter Umgebungstemperatur, ergibt sich eine ungleiche Aufteilung der Ströme in den Pfaden des ersten Stromspiegels M3, M4. Wird beispielsweise die Steilheit $g_{mA}$ des Differenzpaars M1A, M2A kleiner, fließt beispielsweise weniger Strom durch den Transistor M2A und mehr Strom durch den Transistor M1A. Dadurch, dass der Strom im Transistor M4 des ersten Stromspiegels M3, M4 zunächst konstant gehalten wird, fließt auch durch den Transistor M5 des zweiten Stromspiegels M5, M6 ein kleinerer Strom.

Als Konsequenz steigt eine elektrische Gatespannung eines Regeltransistors M7, der mit dem Transistor M6 des zweiten Stromspiegels M5, M6 galvanisch verbunden ist, wodurch über einen vom Transistor M7 angesteuerten dritten Stromspiegel M8, M9 ein größerer Biasstrom $I_{BA}$ des Differenzpaars M1A, M2A getrieben wird. Der Biasstrom $I_{BA}$ wird solange erhöht, bis der Referenzstrom $I_{Ref}$ durch den Transistor M6 fließt und die Steilheit $g_{mA}$ des Differenzpaars M1A, M2A damit dem Vorgabewert der Steilheit $g_{mB}$ des Differenzpaars M1 B, M2B entspricht.

Eine Schnittstelle der Regelungseinrichtung 100 bzw. Referenzstromerzeugungseinrichtung zum Transkonduktanzverstärker 200 wird durch einen vierten Stromspiegel M9, M10 realisiert, wobei der Transistor M9 dafür sorgt, dass durch den Transistor M10 des Stromspiegels M9, M10 der gleiche Strom und damit ein dem Biasstrom $I_{BA}$ entsprechender Biasstrom $I_{BB}$ fließt.

Vorteilhaft kann im Ergebnis auf diese Weise die Steilheit $g_{mB}$ des Differenzpaars M1B, M2B des Transkonduktanzverstärkers 200 mittels der Steilheit $g_{mA}$ der Regelungseinrichtung 100 derart geregelt werden, dass sie im Wesentlichen von äußeren Einflüssen unbeeinflusst ist.

Man erkennt, dass aufgrund der Tatsache, dass das Differenzpaar M1A, M2A eine genaue technologische Replika des zu steuernden Differenzpaars M1B, M2B ist, eine Wirkung von Temperaturvariationen bzw. Prozesseffekte vorteilhaft ausgeglichen werden kann.

Obwohl in der beschriebenen Ausführungsform die beiden Biasströme $I_{BA}$ und $I_{BB}$ identisch sind, ist es auch denkbar, dass ein Übersetzungsverhältnis zwischen den beiden Biasströmen $I_{BA}$ und $I_{BB}$ vorgesehen ist (nicht dargestellt). Das Übersetzungsverhältnis kann dabei beispielsweise durch geeignete geometrische Dimensionierungen von Strukturen der Transistoren M9, M10 realisiert werden.

Die Transkonduktanz bzw. Steilheit des Referenz-Differenzpaares M1A, M2A lässt sich mathematisch folgendermaßen darstellen:

$$g_{m\,M1A,\,M2A} = \Delta I_{Out} / \Delta V_{in} = I_{Ref} / V_{Diff}$$

Die Transkonduktanz wird über eine Aufteilung des Stroms bei gegebener kleiner Spannungsauslenkung am Eingang erfasst und mit einem Soll-Strom verglichen. Der Bias-Strom $I_{BA}$ durch das Differenzpaar M1A, M2A wird nachgeregelt, bis der Istwert dem Sollwert entspricht. Der auf diesem Wege ermittelte Bias-Strom $I_{BA}$ wird auf das Differenzpaar M1B, M2B des Transkonduktanzverstärkers 200 gespiegelt, das damit nahezu dieselbe Steilheit aufweist wie das Referenzpaar M1A, M2A.

Vorteilhaft ist mit diesem Konzept auch ein Umschalten der Steilheit möglich, vorzugsweise durch eine Änderung des Referenzstroms $I_{Ref}$ oder durch eine Wahl eines anderen Abgriffs aus dem Referenzspannungsteiler und damit eine geänderte Differenzspannung $V_{Diff}$. Ferner sind auch adaptive Ansätze durch eine Nachregelung des Referenzstroms $I_{Ref}$ möglich (nicht dargestellt).

Auf diese Weise lässt sich das erfindungsgemäße Konzept gemäß konkreten Anforderungen an eine Steilheit $g_{mB}$ des Transkonduktanzverstärkers 200 effektiv umsetzen.

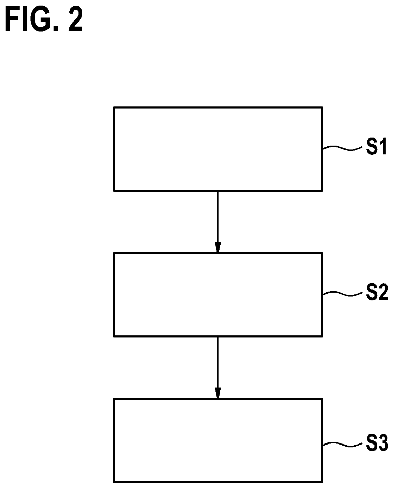

Fig. 2 zeigt anhand eines prinzipiellen Ablaufdiagramms eine Ausführungsform des erfindungsgemäßen Verfahrens zum Betreiben eines Transkonduktanzverstärkers 200 mittels einer Regelungseinrichtung 100,

wobei der Transkonduktanzverstärker 200 und die Regelungseinrichtung 100 gemeinsam integriert ausgebildet sind.

In einem ersten Schritt S1 wird ein Biasstrom $I_{BB}$ für ein Differenzpaar M1B, M2B des Transkonduktanzverstärkers 200 mittels eines Biasstroms $I_{BA}$ eines Differenzpaars M1A, M2A einer Regelungseinrichtung 100 bereitgestellt, wobei das Differenzpaar M1A, M2A als ein Abbild des Differenzpaars M1B, M2B ausgebildet ist, wobei ein erster Stromspiegel M3, M4 galvanisch mit dem Differenzpaar M1A, M2A verbunden ist, wobei ein zweiter Stromspiegel M5, M6 galvanisch mit dem ersten Stromspiegel M3, M4 verbunden ist.

In einem zweiten Schritt S2 wird ein Regeln des Biasstroms $I_{BA}$ für das Differenzpaar M1A, M1B derart durchgeführt, dass ein Strom durch einen Transistor M6 des zweiten Stromspiegels M5, M6 einem Referenzstrom $I_{Ref}$ entspricht.

In einem dritten Schritt S3 wird der Biasstrom $I_{BA}$ des Differenzpaars M1A, M2A mittels eines vierten Stromspiegels M9, M10, der von einem mit dem Transistor M6 verbundenen Transistor M7 angesteuert wird, auf einen Biasstrom $I_{BB}$ des Differenzpaars M1B, M2B des Transkonduktanzverstärkers 200 gespiegelt.

Obwohl die Erfindung vorgehend anhand von konkreten Ausführungsbeispielen beschrieben worden ist, ist sie keineswegs darauf beschränkt. Ein Fachmann wird die beschriebenen Merkmale somit abändern oder kombinieren können, ohne vom Kern der Erfindung abzuweichen.

### Patentansprüche

1. Regelungseinrichtung (100) für einen Transkonduktanzverstärker (200), wobei die Regelungseinrichtung (100) und der Transkonduktanzverstärker (200) gemeinsam integriert ausgebildet sind, wobei die Regelungseinrichtung (100) aufweist:

   - ein erstes Differenzpaar (M1A, M2A), das als ein Abbild eines zweiten Differenzpaars (M1 B, M2B) des Transkonduktanzverstärkers (200) ausgebildet ist;
   - wobei eine Steilheit ($g_{mA}$) des ersten Differenzpaars (M1A, M2A) regelbar ist;
   - wobei die beiden Differenzpaare (M1A, M2A; M1 B, M2B) galvanisch und funktional miteinander gekoppelt sind;
   - wobei eine Steilheit ($g_{mB}$) des zweiten Differenzpaars (M1B, M2B) des Transkonduktanzverstärkers (200) mittels der Steilheit ($g_{mA}$) des ersten Differenzpaars (M1A, M2A) der Regelungseinrichtung (100) regelbar ist
   - eine elektrische Spannungsquelle ($V_{Diff}$) zum Ansteuern des ersten Differenzpaars (M1A, M2A);
   - einen ersten Stromspiegel (M3, M4), der galvanisch mit dem ersten Differenzpaar (M1A, M2A) gekoppelt ist;
   - einen zweiten Stromspiegel (M5, M6) der galvanisch mit einem Ausgang des ersten Stromspiegels (M3, M4) gekoppelt ist, wobei durch einen Ausgangstransistor (M6) des zweiten Stromspiegels (M5, M6) ein Strom leitbar ist, der einem Strom einer Referenzstromquelle ($I_{Ref}$) entspricht;
   - einen mittels des Ausgangstransistors (M6) des zweiten Stromspiegels (M5, M6) derart ansteuerbaren Regeltransistor (M7), dass ein Gleichgewicht zwischen dem Strom des zweiten Stromspiegels (M5, M6) und dem Strom des ersten Stromspiegels (M3, M4) bereitstellbar ist;
   - einen mittels des Regeltransistors (M7) ansteuerbaren dritten Stromspiegel (M8, M9), mit dem ein erster Biasstrom ($I_{BA}$) für das erste Differenzpaar (M1A, M2A) bereitstellbar ist;
   - wobei der Eingangstransistor (M9) des dritten Stromspiegels (M8, M9) Teil eines vierten Stromspiegels (M9, M10) ist, wobei ein Ausgangstransistor (M10) des vierten Stromspiegels (M9, M10) als Stromquelle für den Transkonduktanzverstärker (200) angeordnet ist;
   - wobei mittels des vierten Stromspiegels (M9, M10) ein zweiter Biasstrom ($I_{BB}$) für das zweite Differenzpaar (M1 B, M2B) bereitstellbar ist;
   - wobei der Biasstrom ($I_{BA}$) durch das erste Differenzpaar (M1A, M2A) im Wesentlichen dem zweiten Biasstrom ($I_{BB}$) durch das zweite Differenzpaar (M1 B, M2B) entspricht.

2. Regelungseinrichtung (100) nach Anspruch 1, **dadurch gekennzeichnet, dass** die Differenzspannung ($V_{diff}$) für das erste Differenzpaar (M1A, M2A) der Regelungseinrichtung (100) derart dimensioniert ist, dass der Transkonduktanzverstärker (200) in einem linearen Bereich arbeitet.

3. Regelungseinrichtung (100) nach Anspruch 1 oder 2, **dadurch gekennzeichnet, dass** die Differenzspannung ($V_{Diff}$) und/oder der Referenzstrom ($I_{Ref}$) definiert einstellbar sind.

4. Regelungseinrichtung (100) nach Anspruch 3, wobei zwischen dem ersten Biasstrom ($I_{BA}$) und dem zweiten Biasstrom ($I_{BB}$) ein Übersetzungsverhältnis vorsehbar ist.

5. Transkonduktanzverstärker (200) aufweisend eine Regelungseinrichtung (100) nach einem der Ansprüche 1 bis 4.

6. Verfahren zum Betreiben eines Transkonduktanzverstärkers (200) mittels einer Regelungseinrichtung (100), wobei der Transkonduktanzverstärker (200) und die Regelungseinrichtung (100) gemeinsam integriert ausgebildet sind, aufweisend die Schritte:

- Bereitstellen eines zweiten Biasstroms ($I_{BB}$) für ein zweites Differenzpaar (M1 B, M2B) des Transkonduktanzverstärkers (200) mittels eines ersten Biasstroms ($I_{BA}$) eines ersten Differenzpaars (M1A, M2A) einer Regelungseinrichtung (100), wobei das erste Differenzpaar (M1A, M2A) als ein Abbild des Differenzpaars zweiten (M1B, M2B) ausgebildet ist; wobei ein erster Stromspiegel (M3, M4) galvanisch mit dem ersten Differenzpaar (M1A, M2A) verbunden ist, wobei ein zweiter Stromspiegel (M5, M6) galvanisch mit dem Ausgang des ersten Stromspiegels (M3, M4) verbunden ist;

- Regeln des ersten Biasstroms ($I_{BA}$) für das erste Differenzpaar (M1A, M1 B) derart, dass ein Strom durch einen Ausgangstransistor (M6) des zweiten Stromspiegels (M5, M6) einem Referenzstrom ($I_{Ref}$) entspricht; und

- Spiegeln des ersten Biasstroms ($I_{BA}$) des ersten Differenzpaars (M1A, M2A) mittels eines vierten Stromspiegels (M9, M10), der von einem mit dem Ausgangstransistor (M6) des zweiten Stromspiegels verbundenen Regeltransistor (M7) angesteuert wird, auf einen zweiten Biasstrom ($I_{BB}$) des zweiten Differenzpaars (M1B, M2B) des Transkonduktanzverstärkers (200).

**Claims**

1.  Regulating device (100) for a transconductance amplifier (200), wherein the regulating device (100) and the transconductance amplifier (200) are formed as jointly integrated, wherein the regulating device (100) has:

    - a first differential pair (M1A, M2A), which is formed as a reflection of a second differential pair (M1B, M2B) of the transconductance amplifier (200);
    - wherein a gradient ($g_{mA}$) of the first differential pair (M1A, M2A) can be regulated;
    - wherein the two differential pairs (M1A, M2A; M1B, M2B) are galvanically and functionally coupled to one another;
    - wherein a gradient ($g_{mB}$) of the second differential pair (M1B, M2B) of the transconductance amplifier (200) can be regulated by means of the gradient ($g_{mA}$) of the first differential pair (M1A, M2A) of the regulating device (100);
    - an electrical voltage source ($V_{Diff}$) for actuating the first differential pair (M1A, M2A);
    - a first current mirror (M3, M4), which is galvanically coupled to the first differential pair (M1A, M2A);

    - a second current mirror (M5, M6), which is galvanically coupled to an output of the first current mirror (M3, M4), wherein a current that corresponds to a current of a reference current source ($I_{Ref}$) can be conducted through an output transistor (M6) of the second current mirror (M5, M6) ;
    - a regulating transistor (M7) that can be actuated by means of the output transistor (M6) of the second current mirror (M5, M6) in such a way that an equilibrium between the current of the second current mirror (M5, M6) and the current of the first current mirror (M3, M4) can be provided;
    - a third current mirror (M8, M9) that can be actuated by means of the regulating transistor (M7), which third current mirror can be used to provide a first bias current ($I_{BA}$) for the first differential pair (M1A, M2A);
    - wherein the input transistor (M9) of the third current mirror (M8, M9) is part of a fourth current mirror (M9, M10), wherein an output transistor (M10) of the fourth current mirror (M9, M10) is arranged as a current source for the transconductance amplifier (200);
    - wherein a second bias current ($I_{BB}$) can be provided for the second differential pair (M1B, M2B) by means of the fourth current mirror (M9, M10);
    - wherein the bias current ($I_{BA}$) through the first differential pair (M1A, M2A) substantially corresponds to the second bias current ($I_{BB}$) through the second differential pair (M1B, M2B).

2.  Regulating device (100) according to Claim 1, **characterized in that** the differential voltage ($V_{Diff}$) for the first differential pair (M1A, M2A) of the regulating device (100) is dimensioned in such a way that the transconductance amplifier (200) operates in a linear range.

3.  Regulating device (100) according to Claim 1 or 2, **characterized in that** the differential voltage ($V_{Diff}$) and/or the reference current ($I_{Ref}$) can be set in a defined manner.

4.  Regulating device (100) according to Claim 3, wherein a transformation ratio can be provided between the first bias current ($I_{BA}$) and the second bias current ($I_{BB}$).

5.  Transconductance amplifier (200) having a regulating device (100) according to one of Claims 1 to 4.

6.  Method for operating a transconductance amplifier (200) by means of a regulating device (100), wherein the transconductance amplifier (200) and the regulating device (100) are formed as jointly integrated, said method having the following steps:

- providing a second bias current ($I_{BB}$) for a second differential pair (M1B, M2B) of the transconductance amplifier (200) by means of a first bias current ($I_{BA}$) of a first differential pair (M1A, M2A) of a regulating device (100), wherein the first differential pair (M1A, M2A) is formed as a reflection of the differential pair second (M1B, M2B); wherein a first current mirror (M3, M4) is galvanically connected to the first differential pair (M1A, M2A), wherein a second current mirror (M5, M6) is galvanically connected to the output of the first current mirror (M3, M4);

- regulating the first bias current ($I_{BA}$) for the first differential pair (M1A, M1B) in such a way that a current through an output transistor (M6) of the second current mirror (M5, M6) corresponds to a reference current (Iref); and

- mirroring the first bias current ($I_{BA}$) of the first differential pair (M1A, M2A) by means of a fourth current mirror (M9, M10), which is actuated by a regulating transistor (M7) connected to the output transistor (M6) of the second current mirror, onto a second bias current ($I_{BB}$) of the second differential pair (M1B, M2B) of the transconductance amplifier (200).

**Revendications**

1. Dispositif de régulation (100) pour un amplificateur à transconductance (200), le dispositif de régulation (100) et l'amplificateur à transconductance (200) étant réalisés intégrés ensemble, le dispositif de régulation (100) possédant :

   - une première paire différentielle (M1A, M2A) qui est réalisée sous la forme d'une représentation d'une deuxième paire différentielle (MB1, MB2) de l'amplificateur à transconductance (200) ;
   - une pente ($g_{mA}$) de la première paire différentielle (M1A, M2A) étant régulable ;
   - les deux paires différentielles (M1A, M2A ; M1B, M2B) étant couplées galvaniquement et fonctionnellement l'une à l'autre ;
   - une pente ($g_{mB}$) de la deuxième paire différentielle (M1B, M2B) de l'amplificateur à transconductance (200) étant régulable au moyen de la pente ($g_{mA}$) de la première paire différentielle (M1A, M2A) du dispositif de régulation (100) ;
   - une source de tension ($V_{Diff}$) électrique destinée à commander la première paire différentielle (M1A, M2A) ;
   - un premier miroir de courant (M3, M4) qui est couplé galvaniquement à la première paire différentielle (M1A, M2A) ;
   - un deuxième miroir de courant (M5, M6) qui est couplé galvaniquement à une sortie du premier miroir de courant (M3, M4), un courant qui correspond à un courant d'une source de courant de référence ($I_{Ref}$) pouvant être conduit à travers un transistor de sortie (M6) du deuxième miroir de courant (M5, M6) ;
   - un transistor de régulation (M7) qui peut être piloté au moyen du transistor de sortie (M6) du deuxième miroir de courant (M5, M6) de telle sorte qu'un équilibre entre le courant du deuxième miroir de courant (M5, M6) et le courant du premier miroir de courant (M3, M4) peut être fourni ;
   - un troisième miroir de courant (M8, M9) qui peut être piloté au moyen du transistor de régulation (M7) et avec lequel peut être fourni un premier courant de polarisation ($I_{BA}$) pour la première paire différentielle (M1A, M2A) ;
   - le transistor d'entrée (M9) du troisième miroir de courant (M8, M9) faisant partie d'un quatrième miroir de courant (M9, M10), un transistor de sortie (M9) du quatrième miroir de courant (M9, M10) étant disposé en tant que source de courant pour l'amplificateur à transconductance (200) ;
   - un deuxième courant de polarisation $I_{BB}$) pour la deuxième paire différentielle (M1B, M2B) pouvant être fourni au moyen du quatrième miroir de courant (M9, M10) ;
   - le courant de polarisation ($I_{BA}$) à travers la première paire différentielle (M1A, M2A) correspondant pour l'essentiel au deuxième courant de polarisation ($I_{BB}$) à travers la deuxième paire différentielle (M1B, M2B).

2. Dispositif de régulation (100) selon la revendication 1, **caractérisé en ce que** la tension différentielle ($V_{Diff}$) pour la première paire différentielle (M1A, M2A) du dispositif de régulation (100) est dimensionnée de telle sorte que l'amplificateur à transconductance (200) fonctionne dans une plage linéaire.

3. Dispositif de régulation (100) selon la revendication 1 ou 2, **caractérisé en ce que** la tension différentielle ($V_{Diff}$) et/ou le courant de référence ($I_{Ref}$) peuvent être réglés de manière définie.

4. Dispositif de régulation (100) selon la revendication 3, un rapport de conversion pouvant être prévu entre le premier courant de polarisation ($I_{BA}$) et le deuxième courant de polarisation ($I_{BB}$).

5. Amplificateur à transconductance (200), comprenant un dispositif de régulation (100) selon l'une des revendications 1 à 4.

6. Procédé pour faire fonctionner un amplificateur à transconductance (200) au moyen d'un dispositif de régulation (100), l'amplificateur à transconductance (200) et le dispositif de régulation (100) étant réalisés intégrés ensemble, comprenant les étapes suivantes :

- fourniture d'un deuxième courant de polarisation ($I_{BB}$) pour une deuxième paire différentielle (M1B, M2B) de l'amplificateur à transconductance (200) au moyen d'un premier courant de polarisation ($I_{BA}$) d'une première paire différentielle (M1A, M2A) d'un dispositif de régulation (100), la première paire différentielle (M1A, M2A) étant réalisée sous la forme d'une représentation de la paire différentielle deuxième (MB1, MB2) de l'amplificateur à transconductance (200) ; un premier miroir de courant (M3, M4) étant couplé galvaniquement à la première paire différentielle (M1A, M2A), un deuxième miroir de courant (M5, M6) étant couplé galvaniquement à une sortie du premier miroir de courant (M3, M4) ;

- régulation du premier courant de polarisation ($I_{BA}$) pour la première paire différentielle (M1A, M1B) de telle sorte qu'un courant à travers un transistor de sortie (M6) deuxième miroir de courant (M5, M6) corresponde à un courant de référence ($I_{Ref}$) ; et

- réflexion en miroir du premier courant de polarisation ($I_{BA}$) pour la première paire différentielle (M1A, M2A) au moyen d'un quatrième miroir de courant (M9, M10), lequel est commandé par un transistor de régulation (M7) relié au transistor de sortie (M6) du deuxième miroir de courant, à un deuxième courant de polarisation ($I_{BB}$) de la deuxième paire différentielle (MB1, MB2) de l'amplificateur à transconductance (200).

FIG. 1

# FIG. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070152752 A
- WO 2012120570 A